(19)

**Europäisches Patentamt**
**European Patent Office**
**Office européen des brevets**

(11)  **EP 4 595 210 B1**

(12)  **EUROPEAN PATENT SPECIFICATION**

(45) Date of publication and mention
of the grant of the patent:
**10.06.2026  Bulletin 2026/24**

(21) Application number: **22793646.5**

(22) Date of filing: **30.09.2022**

(51) International Patent Classification (IPC):
$H03F\ 1/32^{(2006.01)}$   $H03F\ 3/195^{(2006.01)}$
$H03F\ 3/68^{(2006.01)}$   $H03F\ 3/24^{(2006.01)}$

(52) Cooperative Patent Classification (CPC):
**H03F 1/3247; H03F 1/3258; H03F 3/195;**
**H03F 3/24; H03F 3/68;** H03F 2200/451;
H03F 2201/3227

(86) International application number:
**PCT/CN2022/123379**

(87) International publication number:
**WO 2024/065725 (04.04.2024 Gazette 2024/14)**

(54) **METHODS AND APPARATUSES FOR PERFOMING DIGITAL PREDISTORTION USING A COMBINATION MODEL**

VERFAHREN UND VORRICHTUNGEN ZUR DURCHFÜHRUNG EINER DIGITALEN VORVERZERRUNG UNTER VERWENDUNG EINES KOMBINATORISCHEN MODELLS

PROCÉDÉS ET APPAREILS POUR EFFECTUER UNE PRÉDISTORSION NUMÉRIQUE À L'AIDE D'UN MODÈLE DE COMBINAISON

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.08.2025  Bulletin 2025/32**

(73) Proprietor: **Telefonaktiebolaget LM Ericsson (publ)**
**164 83 Stockholm (SE)**

(72) Inventors:
• **DIKMESE, Sener**
**174 61 Sundbyberg (SE)**
• **FENG, Ang**
**164 80 Stockholm (SE)**
• **GAN KLINGBERG, Mats**
**182 48 Enebyberg (SE)**
• **GAO, Hao**
**Beijing 100102 (CN)**

(74) Representative: **Ericsson**
**Patent Development**
**Torshamnsgatan 21-23**
**164 80 Stockholm (SE)**

(56) References cited:
**WO-A1-2022/240732**

• **LI YUNFENG ET AL: "Hybrid Digital Pre-Distortion for Active Phased Arrays Subject to Varied Power and Steering Angle", IEEE MICROWAVE AND WIRELESS COMPONENTS LETTERS, IEEE SERVICE CENTER, NEW YORK, NY, US, vol. 32, no. 10, 11 May 2022 (2022-05-11), pages 1243 - 1246, XP011922436, ISSN: 1531-1309, [retrieved on 20220511], DOI: 10.1109/ LMWC.2022.3172215**
• **YU YUCHENG ET AL: "Self-Sensing Digital Predistortion of RF Power Amplifiers for 6G Intelligent Radio", IEEE MICROWAVE AND WIRELESS COMPONENTS LETTERS, IEEE SERVICE CENTER, NEW YORK, NY, US, vol. 32, no. 5, 11 January 2022 (2022-01-11), pages 475 - 478, XP011907829, ISSN: 1531-1309, [retrieved on 20220111], DOI: 10.1109/LMWC.2021.3139018**
• **ALEXANDRU CIOBA ET AL: "Efficient attention guided 5G power amplifier digital predistortion", ARXIV.ORG, CORNELL UNIVERSITY LIBRARY, 201 OLIN LIBRARY CORNELL UNIVERSITY ITHACA, NY 14853, 30 March 2020 (2020-03-30), XP081631549**

EP 4 595 210 B1

- **FENG X ET AL: "Digital predistortion method combining memory polynomial and feed-forward neural network", ELECTRONICS LETTERS, THE INSTITUTION OF ENGINEERING AND TECHNOLOGY, GB, vol. 51, no. 12, 11 June 2015 (2015-06-11), pages 943 - 945, XP006052485, ISSN: 0013-5194, DOI: 10.1049/EL.2015.0276**

**Description**

Technical Field

Embodiments described herein relate to methods and apparatuses for performing digital predistortion using a combination model, and methods and apparatuses for training such a combination model.

Background

Generally, all terms used herein are to be interpreted according to their ordinary meaning in the relevant technical field, unless a different meaning is clearly given and/or is implied from the context in which it is used. All references to a/an/the element, apparatus, component, means, step, etc. are to be interpreted openly as referring to at least one instance of the element, apparatus, component, means, step, etc., unless explicitly stated otherwise. The steps of any methods disclosed herein do not have to be performed in the exact order disclosed, unless a step is explicitly described as following or preceding another step and/or where it is implicit that a step must follow or precede another step. Any feature of any of the embodiments disclosed herein may be applied to any other embodiment, wherever appropriate. Likewise, any advantage of any of the embodiments may apply to any other embodiments, and vice versa. Other objectives, features and advantages of the enclosed embodiments will be apparent from the following description.

Massive multiple input multiple output (M-MIMO) oriented systems are considered to be one of the key enablers in terms of enhanced spectral and energy efficiency in today's wireless communication networks (e.g. fourth generation (4G) long term evolution (LTE) / fifth generation (5G) and 5G beyond based systems).

Three structures of beamforming, namely "analog", "digital" and "hybrid analog-digital (HAD)" beamforming, are considered (see references [1] to [4]). Fully digital beamforming at the transmitter, which requires a dedicated transmitter chain for each antenna, may comprise huge hardware and computational complexity. In contrast, analog beamforming at the transmitter, implemented by a set of phase shifters, requires less hardware cost and power consumption. However, the capacity of analog beamforming is constrained by the low degree of freedom.

Due to the aforementioned limitations associated with solely analog or solely digital beamforming, a HAD beamforming transmitter may be considered to provide a better balance between cost and capacity given that the overall transmitter comprises antenna subsystems of some number of antennas, which are connected to a single radio frequency (RF) transmitter chain via a time-domain beamforming unit.

In wireless communication devices, such as base stations and user equipments (UEs), nonconstant-envelope I/Q modulated signals such as orthogonal frequency division multiplexing (OFDM) and filtered OFDM are used for 4G LTE and 5G, respectively. These signals together with M-MIMO systems naturally excite the nonlinearities of the transmitter, especially of the power amplifier (PA). Additionally, the power efficiency of the power amplifiers, which are the most power-hungry components in the devices, may be required to be as high as possible.

Different compensation approaches for the nonlinearities of power amplifiers are considered in the state-of-the-art literatures (see references [1] to [5]). Digital predistortion (DPD), which is commonly used in both academia and industry, is becoming more and more popular in both the single antennal small number of antennas systems and in large-scale antennas/M-MIMO systems.

Polynomial based models, such as a memory polynomial (MP) and generalized MP (GMP), have been widely used for DPD in both industry and academia (see references [4] and [6]). Herein, the term MP model will be used to encompass both MP and GMP models.

While MP models naturally give significant modeling performance in single antennalsmall number of antenna systems, an MP model requires huge computational complexity, due to the necessity of having DPD in each transmitter chain, in digital beamforming of large-scale antenna/M-MIMO systems. In addition, as an MP model is only valid within a narrow power range, this property is becoming a limiting factor in their applicability.

With the growing attention on wireless communications, the evolution of emerging RF systems has brought distinct features with new challenges for the compensation of power amplifier nonlinearities. Complex power amplifier architectures, such as multiband and multimode power amplifiers, which significantly improve the energy efficiency of the system, are difficult to be compensated in terms of the nonlinearity with the desired linear gain.

On the other hand, with the new waveforms such as new radio (NR) in 5G and 5G beyond including the wider signal bandwidth, it is becoming more critical to compensate the nonlinearity and the memory effects accurately over wider frequency range (see references [4] to [8]).

In addition to the above challenges in a single antenna system and/or traditional small number of antenna systems, the spectral efficiency and the energy efficiency, both of which are fundamental objectives of M-MIMO, are compromised (see references [5] and [11]). The out-of-band emission due to power amplifier nonlinearity is investigated in both the single antenna and M-MIMO transmitter scenarios (see references [5] and [8]). According to the results, due to the M-MIMO structure, adjacent channel emission power ratio (ACEPR), also referred to as adjacent channel leakage ratio (ACLR), caused by power amplifier nonlinearity is, on average, equal to the single antenna scenario when transmitting with the same total sum-power. This emphasizes that when a highly nonlinear power amplifier is used per RF chain, tremendous out-of-band emission/distortion is caused in M-MIMO structures that creates more interference on neighboring channel transmissions with respect to the single antenna configuration and/or violates the spurious emission limits.

In terms of the quality of the signal under power amplifier nonlinearity, significant error vector magnitude (EVM) degradation is shown in reference [12] in a M-MIMO base station. Additionally, at least 6 dB backoff is required to reach the maximum targeted data rate (see reference [12]). Additionally, when practical models are considered as in reference [13], there is significant degradation on the signal to interference plus noise ratio (SINR).

When the power amplifier nonlinearity is present due to practical power amplifiers, the most harmful distortions are in the same direction as the main beam in the case of a single user per array and line- of-sight (LOS). In an example scenario in which a victim user lies in the same direction as an intended user, this creates significant interference to the victim user.

LI YUNFENG ET AL: "Hybrid Digital Pre-Distortion for Active Phased Arrays Subject to Varied Power and Steering Angle", IEEE MICROWAVE AND WIRELESS COMPONENTS LETTERS, IEEE SERVICE CENTER, NEW YORK, NY, US, vol. 32, no. 10, 11 May 2022 (2022-05-11), pages 1243-1246 discloses memory polynomial (MPM)-aided deep neural network (DNN) digital pre-distortion (MaD-DPD) method for active phased arrays (APAs) subject to varied input power and steering angle. The model uses only two varied APA state parameters (input power· and steering angle) as input and the MPM coefficients as regression target, eliminating the need for model parameter updating.

The use of backoff instead of enhanced DPD solutions may be an alternative solution to compensate the non-linear distortion of power amplifiers, but this is not an attractive approach due to the requirement of using larger power amplifiers operating in the linear region. The use of backoff also creates a problem with both the cost and size of each RF chain, which would increase, and the energy efficiency, which would decrease.

In addition to above mentioned challenges, in today's M-MIMO structures such as 4G LTE-A and 5G, the transmission power varies with real-time traffic. This may also be referred to as "dynamic traffic effects". These effects mean that the dynamic changes appearing on the power amplifier inputs can have significant impact on the nonlinear behavior of each power amplifier. This may result in an exponential impact when the M-MIMO transmitter is considered.

Summary

According to some embodiments there is provided a method of performing digital predistortion, DPD, such as defined in independent claim 1.

According to some embodiments there is provided a method of training a combination model for performing digital predistortion such as defined in independent claim 7.

According to some embodiments there is provided a DPD module for performing digital predistortion, DPD, such as defined in independent claim 8.

According to some embodiments there is provided a DPD module for training a combination module to perform digital predistortion, DPD, such as defined in independent claim 10.

Further embodiments are defined in the dependent claims.

Aspects and examples of the present disclosure thus provide methods and apparatuses for performing DPD, in particular, for performing DPD in the context of HAD MIMO beamforming.

For the purposes of the present disclosure, the term "ML model" encompasses within its scope the following concepts:

Machine Learning (ML) algorithms, comprising processes or instructions through which data may be modified by a model artefact for performing a given task, or for representing a real world process or system;
the model artefact that is created, and may be updated by a training process, and which comprises the computational architecture that performs the task; and
the process performed by the model artefact in order to complete the task.

References to "ML model", "model", "model parameters", "model information", etc., may thus be understood as relating to any one or more of the above concepts encompassed within the scope of "ML model".

Brief Description of the Drawings

For a better understanding of the embodiments of the present disclosure, and to show how it may be put into effect, reference will now be made, by way of example only, to the accompanying drawings, in which:

Figure 1a illustrates an example of a HAD beamforming system 100 according to some embodiments;

Figure 1b illustrates an example scenario for a HAD beamforming system 100 in which a victim wireless device lies in the same direction as an intended wireless device;

Figure 2 illustrates an example of a DPD module 102a;

Figure 3 illustrates a method of performing digital predistortion, DPD;

Figure 4 illustrates an example of how the combination model may be implemented;

Figure 5 illustrates a method of training a combination model;

Figure 6 illustrates an DPD module comprising processing circuitry;

Figure 7 is a block diagram illustrating an DPD module;

Figure 8 illustrates an DPD module comprising processing circuitry;

Figure 9 is a block diagram illustrating an DPD module;

Figure 10 illustrates normalised power spectral density as a function of frequency for signals without DPD, with ML assisted MP based DPD, and with ML based DPD under static traffic conditions;

Figure 11 illustrates normalised power spectral density as a function of frequency for signals without DPD, with ML assisted MP based DPD, and with ML based DPD under dynamic traffic conditions.

Detailed Description

The following sets forth specific details, such as particular embodiments or examples for purposes of explanation and not limitation. It will be appreciated by one skilled in the art that other examples may be employed apart from these specific details. In some instances, detailed descriptions of well-known methods, nodes, interfaces, circuits, and devices are omitted so as not obscure the description with unnecessary detail. Those skilled in the art will appreciate that the functions described may be implemented in one or more nodes using hardware circuitry (e.g., analog and/or discrete logic gates interconnected to perform a specialized function, ASICs, PLAs, etc.) and/or using software programs and data in conjunction with one or more digital microprocessors or general-purpose computers. Nodes that communicate using the air interface also have suitable radio communications circuitry. Moreover, where appropriate the technology can additionally be considered to be embodied entirely within any form of computer-readable memory, such as solid-state memory, magnetic disk, or optical disk containing an appropriate set of computer instructions that would cause a processor to carry out the techniques described herein.

Hardware implementation may include or encompass, without limitation, digital signal processor (DSP) hardware, a complex instruction set computer (CISC), a reduced instruction set computer (RISC), hardware (e.g., digital or analog) circuitry including but not limited to application specific integrated circuit(s) (ASIC) and/or field programmable gate array(s) (FPGA(s)), and (where appropriate) state machines capable of performing such functions.

Machine Learning (ML) approaches for performing DPD may be considered to be of interest due to the prosperity of ML community. However, traditional decision tree (DT), random forest (RaF), gradient boosting (GB) tree and neural network (NN) based ML methods, have not been studied previously for DPD structures in the context of HAD beamforming M-MIMO. It is noticed that a single ML model cannot handle such challenging issue. Due to this, it will be appreciated that a combination model such as described in embodiments herein may be required.

In contrast, ML approaches proposed on both static traffic (as an idealistic environment) and on dynamic traffic (as a realistic environment) are only currently considered in the context of a single power amplifier. It has been noted that a single ML model cannot handle such challenging issue either.

It will be shown herein that application of ML approaches in a HAD beamforming M-MIMO with both static and dynamic traffic is not straightforward. The resulting performance using only ML approaches cannot meet the requirements on EVM and ACEPR.

Embodiments described herein therefore utilize ML assisted MP based DPD on beamforming M-MIMO structures. In other words, embodiments described herein utilize both an ML model and an MP model to perform DPD. In some examples, HAD beamforming M-MIMO structures are used. In some examples, digital beamforming M-MIMO structures are used.

Fully digital beamforming, in which a dedicated DPD unit for each transmitter is used, requires huge cost and computational complexity in the base stations and/or wireless devices. HAD beamforming may therefore be preferred as it requires less cost and computational complexity for M-MIMO structures. For HAD beamforming, since the DPD is operating in the digital baseband, a single DPD may linearize all the power amplifiers in an RF chain simultaneously. This is essentially an underdetermined problem and commonly leads to reduced linearization performance for the individual power amplifiers.

When the power amplifier nonlinear characteristics for a number of antennas are assumed to be very similar (which may not be true in the practice), the linearization performance does not decrease significantly. In embodiments described herein, different power amplifier characteristics are considered to be consistent with the practical case, in other words, the power amplifier characteristics are not assumed to be similar.

The embodiments described herein utilizing an ML assisted MP based DPD method result in a robust performance in HAD beamforming M-MIMO under static and dynamic traffic, thanks to the modeling of the different power amplifier characteristics.

As an example, a GB tree assisted MP based approach, which provides a prediction model in the form of an ensemble of weak prediction models, may be considered one of the best performing tree-based ML approaches considered herein. To increase the performance of traditional tree-based methods, boosting as an optimization algorithm on a suitable cost function may be applied.

In general, ML algorithms are designed to work with real-valued signals only. It will be appreciated that the ML model used may therefore first be adapted to handle complex-valued signals.

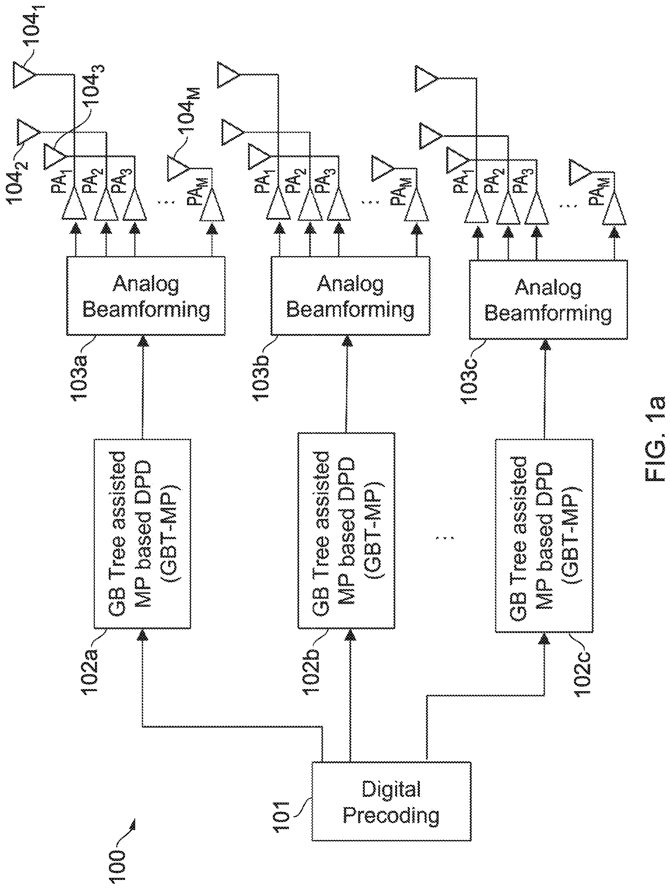

**Figure 1a** illustrates an example of a HAD beamforming system 100 according to some embodiments.

The HAD beamforming system comprises a digital precoding module 101 configured to perform precoding.

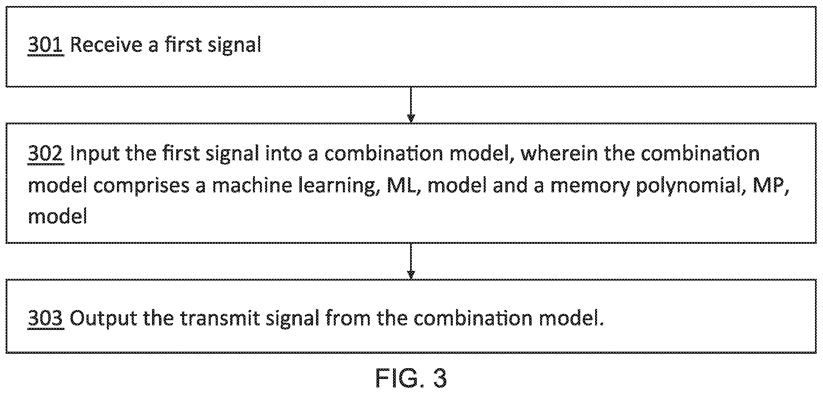

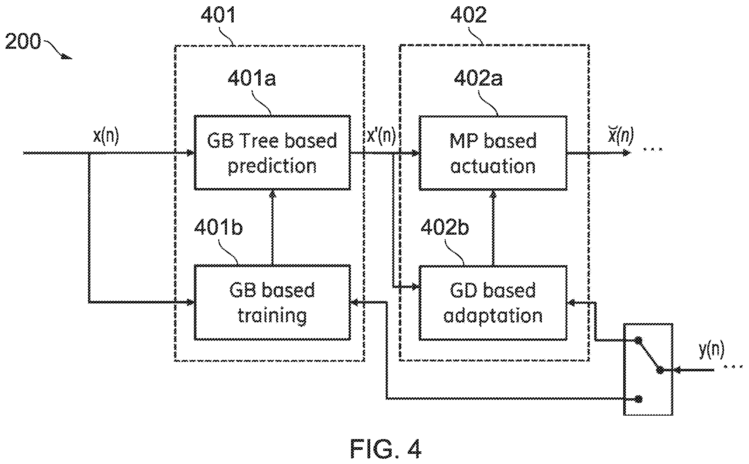

The HAD beamforming system further comprises multiple RF chains, for example three RF chains. Each RF chain comprises a DPD module 102a to 102c according to embodiments described herein. The function of each DPD module 102a to 102c will be described in more detail with reference to Figures 3 and 4. The output of each digital beamforming module is used to drive an analog beamforming module 103a to 103c. Each analog beamforming module 103a to 103c then, in turn, drives a plurality of power amplifiers $PA_1$ to $PA_M$ coupled to a plurality of antenna elements $104_1$ to $104_M$ (not all numbered for clarity).

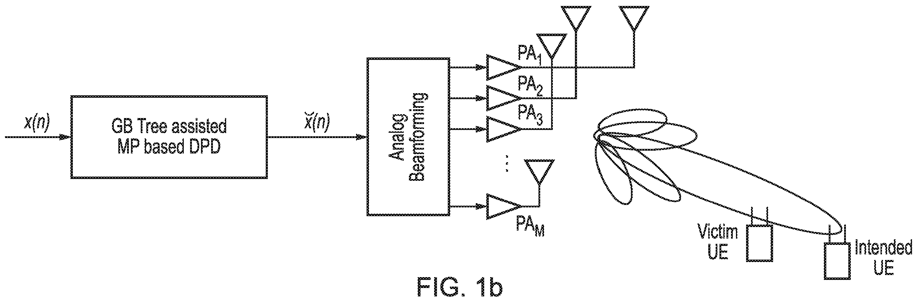

Figure **1b** illustrates an example scenario for a HAD beamforming system 100 in which a victim wireless device lies in the same direction as an intended wireless device. For sake of simplicity, only one RF chain and its related components are plotted in the figure. The scenario illustrated in Figure 1a may be considered as a worst-case scenario and in this example, out-of-band emissions may be similar to the classical emission scenarios and can be quantified using an ACEPR metric. Compensation of the power amplifier nonlinearities with DPD plays a crucial role in HAD beamforming M-MIMO for real life transmissions.

Embodiments described herein therefore make use of a combination model in order to compensate for the power amplifier nonlinearities.

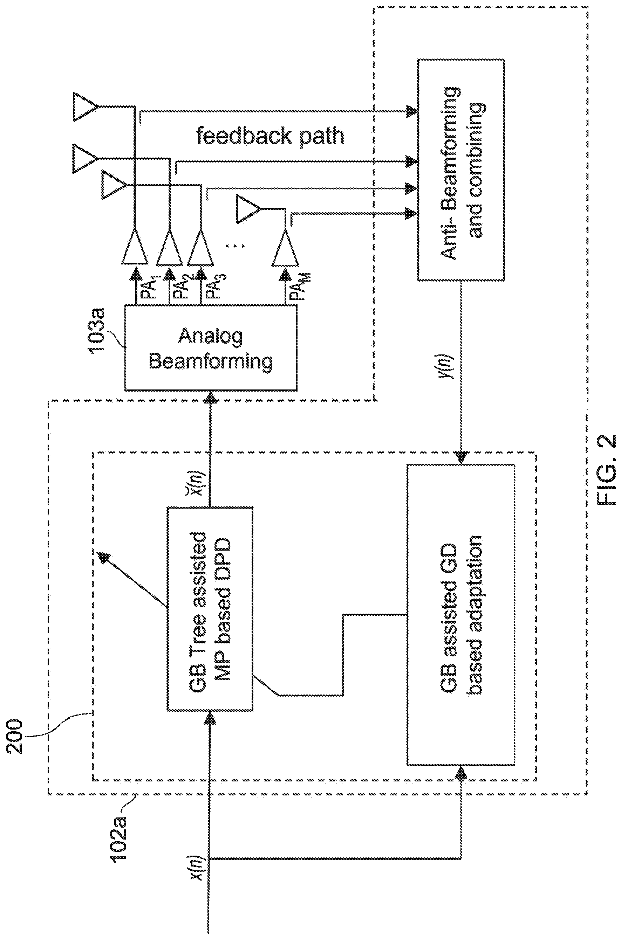

Figure 2 illustrates an example of a DPD module 102a. It will be appreciated that the DPD modules 102b and 102c illustrated in Figure 1a may comprise similar features to those described in Figure 2 with reference to DPD module 102a.

The DPD module 102a comprises a combination model 200. The combination model 200 may be configured to receive a first signal $x(n)$. The combination model 200 may then be trained or adapted based on a feedback signal $y(n)$ and the first signal $x(n)$. The feedback signal $y(n)$ may be derived from an output of the antenna elements which are driven by one or more amplifier signals $\breve{x}_m(n)$ derived from a transmit signal $\breve{x}(n)$ that is output from the combination model 200.

In the example illustrated in Figure 2, as HAD beamforming is utilized, the transmit signal is used to derive a plurality of amplifier signals $\breve{x}_m(n)$. These amplifier signals $\breve{x}_m(n)$ are derived by inputting the transmit signal into an analog beamforming module 103a.

It will be appreciated that the baseband equivalent amplifier signal driving the m-th power amplifier may be expressed as:

$$\breve{x}_m(n) = w_m \, \breve{x}(n),$$

where $\breve{x}(n)$ comprises the base band equivalent transmit signal output by the combination model 200, $w_m$ corresponds to the analog beamforming coefficient applied for the m-th antenna element. When $|w_m| = 1$ it is assumed that no amplitude tapering is performed and only phase rotations are applied in the analog beamforming stage. The beamforming coefficients $w_m$ may be generally selected so that most of the power is radiated/directed in an intended receiving direction (for example as illustrated later in Figure 2).

The baseband equivalent output signal of the m-th power amplifier may be modelled as:

$$y_m(n) = \sum_j \sum_i F(|\breve{x}_m(n - d_i)|)\breve{x}_m\left(n - d_j\right)$$

where F denotes a nonlinear function and $d_i$ and $d_j$ are memory terms contained in the model. The feedback signal $y(n)$ which may be obtained from the output of the $M$ antenna elements may be expressed as follows:

$$y(n) = \sum_{m=1}^{M} w_m^* y_m(n) = M \sum_j \sum_i F(|\breve{x}(n - d_i)|)\breve{x}(n - d_j)$$

Figures 1a and 2 illustrate a DPD module 102a being used in a HAD beamforming system. It will however be appreciated that a DPD module 102a according to embodiments described herein may be utilized in a digital beamforming system. In these examples, a DPD module may be provided for each power amplifier, and the amplifier signal $\breve{x}_m(n)$, driving the power amplifier may comprise the transmit signal $\breve{x}(n)$ that is output from the combination model 200.

Figure 3 illustrates a method of performing digital predistortion, DPD, to provide a transmit signal, $\breve{x}(n)$, wherein the transmit signal, $\breve{x}(n)$, is for deriving one or more amplifier signals, $\breve{x}_m(n)$, for driving one or more power amplifiers. The method of Figure 3 may be performed by each DPD module 102a to 102c illustrated in Figure 1.

The one or more power amplifiers may be associated with a respective one or more antenna elements.

In step 301 the method comprises receiving a first signal, $x(n)$. The first signal may comprise online or offline training data.

In step 302, the method comprises inputting the first signal, $x(n)$, into a combination model, wherein the combination model comprises a machine learning, ML, model and a memory polynomial, MP, model.

An example of how the combination model may be implemented is illustrated in Figure 4.

As can be seen in Figure 4, the combination model 200 comprises a ML model 401 and a MP model 402. It will be appreciated that the ML model 401 may comprise any suitable ML model. For example, the ML model 401 may comprise a tree based ML model (e.g. a decision tree model, a random forest based model or a gradient boosting tree model). In other examples, the ML model 401 may comprise a neural network, NN, based model.

In the example illustrated in Figure 4, the MP model 402 is configured to receive an output $x'(n)$ of the ML model 401. It will however be appreciated that the combination model may be implemented in the reverse order, and the ML model 401 may be configured to receive an output of the MP model.

In step 303, the method comprises outputting the transmit signal $\breve{x}(n)$, from the combination model.

For example, returning to Figure 4, the ML model 401 may comprise a tree based model. For example, GB Trees based prediction 401a may be applied with a coefficient that is updated by using GB based learning 401b. This example is described in more detail below in the section entitled "GBT assisted DPD".

For the MP model 402, traditional MP based actuation 402a may be applied with a coefficient that is updated by using Gradient Descent (GD) based adaptation 402b. This example is described in more detail below in the section entitled "MP based DPD"

GB Tree assisted DPD

As described above, the ML model 401 part of the combination model 200 may implement GB Tree based prediction and GB based training/learning to improve the performance of DPD on HAD beamforming M-MIMO.

Traditional decision trees, which may be considered as one of the tree-based ML approaches that performs both classification and regression, can separate the input space into different dimensions. The traditional decision trees only consider real values of the input signals. It will be appreciated that the model may require extension to support complex values. A straightforward modification may be to split the real and imaginary parts of the samples and feed them separately. Meanwhile, the memory effects of the PA need to be considered carefully. With this process, the model output signals can be dependent on not only the current input signals, but also the previous input signals.

Using a single DT, only a few critical features may be applied, and due to this, full characterization of the power amplifier behaviour may not be achieved. To overcome this disadvantage of traditional DT based ML methods, GB regression-based ML techniques may be used, which increases the linearization performance in DPD, and may be defined as an ensemble of DTs. GB techniques predicts the desired output based on the additive regression model which uses a DT as a weak learner fitting of a parameterized function to current "pseudo"-residuals. A GB based ML approach is applied at each iteration by optimizing regression loss such as absolute error instead of having one tree. "Pseudo" residuals may be described as the minimization of the gradient of a loss function with respect to values of the regression model at each training data set for the current step. Due to the randomization in the process of training data set selection, this GB based ML approach improves the accuracy and also reduces the possibility of overfitting. The implementation of the modified/improved version of DT may minimize the errors at each next step, and therefore the GB based ML approach may be considered as more reliable and robust compared to a traditional DT regressor.

A common regression problem may be expressed as follows:

Given $N$ training data $D = \{(x_1,y_1), (x_2,y_2)... (x_N,y_N)\}$, in which $x_i$ belongs to a set $\chi \subset \mathbb{R}^m$ and represents a feature vector involving m features, and $y_i \in \mathbb{R}$ represents the observed output or the target value such that $y_i = f(x_i) + \varepsilon$. Here, $\varepsilon$ is the error (non-linear distortion) with expectation of a small value such as 0 and unknown finite variance.

The ML targets to construct a regression model or an approximation $g$ of the function $f$ that minimizes:

$$L(f) = \mathbb{E}_{(x,y)\sim P} l\big(y, g(x)\big) = \int_{\chi \times \mathbb{R}} l\big(y, g(x)\big) d\mathrm{T}(x,y),$$

with respect to the function parameters. Here $T(x, y)$ is a joint probability distribution of $x$ and y; and the loss function $l(.,.)$ can be represented as follows

$$l\big(y, g(x)\big) = (y - g(x))^2.$$

Specifically, GB regression, which is one of the powerful ML algorithms, is an iterative process of a model as an ensemble of base prediction models built in a stage-wise fashion where each base model is constructed, based on data obtained using an ensemble of models already built on previous iterations, as an approximation of the loss function derivative. A model of size $\Omega$ is a linear combination of $\Omega$ base models:

$$g_\Omega(x) = \sum_{i=0}^{\Omega} \gamma_i h_i(x)$$

where $h_i$ is the i-th base model; $\gamma_i$ is the i-th coefficient or the i-th base model weight.

The GB algorithm may be explained with the following steps:

1. Initialize the zero-base model $h_o(x)$, for instance, with a constant value.

2. Compute the residual $r_i^{(t)}$ as a partial derivative of the expected loss function $L(x_i,y_i)$ at each point of the training data-set, i = 1, 2 ... N.

3. Build the base model $h_t(x)$ as regression on residuals $\{(x_i, r_i^{(t)})\}$;

4. Obtain the optimal coefficient $\gamma_t$ at $h_t(x)$ with respect to the initial expected loss function;

5. Update the entire model $g_t(x) = g_{t-1}(x) + \gamma_t h_t(x)$;

6. If the value does not reach the stop criteria, move to step 2.

The loss function depends on the ML problem solved. Assume that $(\Omega - 1)$ steps produce the model $g_{\Omega-1}(x)$. The model $h_\Omega(x)$ may be built for constructing the model $g_\Omega(x)$ as follows:

$$g_\Omega(x) = \sum_{t=1}^{\Omega} \gamma_t h_t(x) = g_{\Omega-1}(x) + \gamma_\Omega h_\Omega(x).$$

The data-set for building the model $h_\Omega(x)$ may be selected to approximate the expected loss function partial derivatives with respect to the function of the previously constructed model $g_{\Omega-1}(x)$. The residuals $r_i^{(\Omega)}$ may be determined as the values of the loss function partial derivative at point $g_{\Omega-1}(x_i)$ in the current iteration $\Omega$,

$$r_i^{(\Omega)} = -\left.\frac{\partial L(z, y_i)}{\partial z}\right|_{z=g_{\Omega-1}(x_i)}$$

By applying the residuals, a new training set $D_\Omega$ may be calculated as follows:

$$D_\Omega = \{(x_i, r_i^{(\Omega)})\}_{i=1}^N$$

and the model $h_\Omega$ may be built on $D_\Omega$ by solving the below optimization:

$$min \sum_{i=1}^N \left\| h_\Omega(x_i), r_i^{(\Omega)} \right\|^2.$$

Therefore, an optimal coefficient $\gamma_\Omega$ of the gradient descent may be calculated as:

$$\gamma_\Omega = \arg\min_\gamma \sum_{i=1}^N L[g_{\Omega-1}(x) + \gamma\, h_\Omega(x_i), y_i].$$

Finally, following the model at every point $x_i$ of the training set can be expressed as follows:

$$g_\Omega = g_{\Omega-1}(x) + \gamma_\Omega\, h_\Omega(x) \approx g_{\Omega-1}(x) - \gamma_\Omega \left. \frac{\partial L(z, y_i)}{\partial z} \right|_{z=g_{\Omega-1}(x_i)}$$

Which is related to the residuals $r_i^{(\Omega)} = -\left. \frac{\partial L(z,y_i)}{\partial z} \right|_{z=g_{\Omega-1}(x_i)}$ .

A cost function may comprise a quadratic function which is differentiable with respect to the input argument.

For example, the cost function may be as follows:

$$L(z, y_i) = (z - y_i)^2.$$

In this example the derivative of the cost function may be given as:

$$\frac{\partial L(z,y_i)}{\partial z} = 2z(z - y_i).$$

It will be appreciated that, except in the case of some special functions, it is not difficult to calculate the derivative of most functions in practice.

The algorithm as described above minimizes the expected loss function by applying decision trees as base models. The parameters of the Gradient Boosting (GB) based approach above may comprise for example: depths of trees, a learning rate, and/or a number of iterations. These parameters may be experimentally tested to provide the best performance. The GB method may be considered a powerful and efficient method to solve regression problems, which can cope with complex non-linear function dependencies.

MP based DPD

Memory polynomials (MP) may be used as a foundation of parametric models for linearization of power amplifiers. The transmit signal may be expressed as:

$$\breve{x}(n) = \sum_{i=0}^{I-1} \sum_{p=0}^{\frac{P}{2}-1} a_{i,p} |x(n - D_i)|^{2p} x(n - D_i)$$

To handle additional cross memory terms in wideband signal, generalized MP (GMP) is presented as well, whose expression is given by:

$$\breve{x}(n) = \sum_{j=0}^{J-1} \sum_{i=0}^{I-1} \sum_{p=0}^{\frac{P}{2}-1} a_{i,j,p} |x(n - D_i)|^{2p} x(n - D_j)$$

Where $a_{i,j,p}$ ($a_{i,p}$ in MP) denotes the coefficient of GMP model, P denotes the polynomial order, and $D_i$ and $D_j$ denote the tap delays, respectively.

Basically, an MP model (which as previously discussed may refer to an MP or a GMP model) may be considered to provide excellent performance for a single power amplifier with static traffic.

In the meantime, thanks to its low cost of implementation, MP based DPD has been recognized as a popular model for linearization of a nonlinear power amplifier. However, in the context of HAD beamforming, since M branches of power amplifiers are linearly combined with corresponding beam coefficients, the resulting behavior is a challenge for MP based DPD.

Compared to linearization of single power amplifier, an MP model suffers from performance degradation in the linearization of combined power amplifiers. Furthermore, dynamic traffic is also a headache for MP based DPD. Normally, an MP model is good at characterization of nonlinear behavior in a small (amplitude) dynamic range. Greater (amplitude) dynamic ranges, however, reduce the accuracy of MP models. Unfortunately, dynamic traffic is unavoidable practically in the operating network.

The coefficient of MP model, i.e. $a_{i,j,p}$ ($a_{i,p}$ in MP) is computed by a gradient descent (GD) algorithm. The purpose of adaptation of the MP model may be understood as minimizing the squared error between the feedback signal $y(n)$ and the first signal $x(n)$. The GD algorithm may be expressed as:

$$a_{i,j,p}^{l+1} = a_{i,j,p}^{l} - \mu \nabla J(a_{i,j,p}^{l})$$

where $\mu$ is the step size. $\mu$ may be selected such that the converging rate and residual error are balanced.

An objective function $J(a_{i,j,p})$ may be defined as:

$$J(a_{i,j,p}) = \sum_{n} |x(n) - y(n)|^2$$

The gradient $\nabla J(a_{i,j,p})$ denotes the partial derivative of $J(a_{i,j,p})$ with respect to $a_{i,j,p}$, which is given by:

$$\nabla J(a_{i,j,p}) = M \sum_{n} |x(n - D_i)|^{2p} x(n - D_j)^* (x(n) - y(n))$$

Eventually, the objective function will converge to the minimum value.

Training Strategies

In the above sections, the training of the MP model and the ML model is discussed, respectively. However, for the cascading structure of the combination model 200 as described in Figure 4, there may be several strategies for training the whole combination model 200.

For example, an intuitive way may be to calculate partial derivatives of error with respect to the parameters via back-propagation, so that the whole combination model 200 may be trained simultaneously. However, propagating gradients between several models is prohibitive in such a complicated system.

Considering the different computational complexities for training the MP model and the ML model, an alternative may be to train the two models separately such that one model is being trained whilst training of the other model is disabled.

It will be appreciated that the updating of the ML model and the MP model may be based on the received feedback signal $y(n)$, and the first signal $x(n)$.

In the first strategy, MP model and GB tree model are updated periodically and alternately. For example, odd number iterations, the MP model is updated, while in even number iterations, the ML model is updated.

In some examples therefore the method of Figure 3 further comprises, during a first time period, performing training of the ML model using the feedback signal, $y(n)$ and the first signal $x(n)$; and during the first time period disabling training of the MP model.

Similarly, the method of Figure 3 may further comprise, during a second time period, performing training of the MP model using the feedback signal, $y(n)$ and the first signal $x(n)$; and during the second time period disabling training of the ML model.

In some examples, the method of Figure 3 comprises training the MP model and the ML model using the feedback signal $y(n)$ and the first signal $x(n)$ by performing periodic and alternate updates to the MP model and the ML model.

In the second strategy, the MP model or ML model may be updated responsive to a request from a DPD controller.

The DPD controller may be comprised in an application specific integrated circuit (ASIC) or field programmable gate array (FPGA) in a radio unit of a base station or a component in a user equipment. A software DPD controller may be implemented in a central processing unit (CPU) built on a Complex Instruction Set Computer (CISC), Reduced Instruction Set Computer (RISC) or advanced RISC machine (ARM).

For example, the method of Figure 3 may comprise triggering the start of the first time period in response to a request to update the ML model. The request to update the ML model may for example occur only once during carrier setup. The ML model may then be frozen after carrier setup unless a new request is received.

The method of Figure 3 may further comprise triggering the start of the second time period in response to a request to update the MP model. The request to update the MP model may for example be requested occasionally to handle other effects.

In some examples, the update of the MP model may be requested only once during the carrier setup and thereafter the MP model may be frozen after carrier setup unless a new request is received. In the meantime, the update of the ML model may be requested to work occasionally to handle other effects.

The second strategy may require intervention and signaling from the DPD controller. Therefore, compared to the first strategy, the second strategy comprises extra overhead in signaling. However, the second strategy is more flexible than the first strategy, and more power efficient, because the training algorithms are enabled or disabled on demand.

Additionally, the ML model and the MP model may be trained either offline and/or online.

In offline training, the ML model may be completed offline in the different periods such as once in a week, month, year, and the saved network may be used for prediction considering any test signals. Because of the less complex implementation, the prediction may be completed with the saved data with online implementation. Alternatively, both the training and prediction may be online.

It will be appreciated that DPD models are relevant to either the input signal's statistics or the power amplifiers behavioral characteristics.

In the example illustrated in Figure 4, during training of the ML model the power amplifiers characteristics have been corrected by the MP model in the last iteration. Updating the ML model may then be to accommodate any new behavior caused by the combined effects of the MP model and the power amplifier.

In the training of MP model, the input signal's statistics has been modified by the ML model in the last iteration. Updating MP model may then be to accommodate the new input statistics that consider the modification of ML model in the input signal.

If the training is completed once in a month, half year or a year based on the environmental change, GB based prediction with saved network from training process is enough. In this way, power saving in other mean energy efficiency can be achieved.

Additionally, a power feature extraction process may be applied on ML assisted MP based DPD on HAD beamforming M-MIMO to obtain improved performance under both the static and dynamic traffic conditions.

This power feature extraction process, which may be applied in the ML assisted MP based DPD approach, is an additional process to successfully compensate the dynamic traffic effects on HAD beamforming M-MIMO structures.

The power feature extraction process may comprise utilizing one or more of: a moving-average (MA) filter, an exponential moving-average (EMA) filter, an autoregressive (AR) filter, an autoregressive moving-average (ARMA) filter and a symbol-based (SB) filter.

Based on the input from the power feature extraction stage, a different label may be applied to finalize the power feature extraction process.

The embodiments described herein achieve very high DPD compensation performance (as will be illustrated below in the section entitled "Simulation Results") with less required memory (hardware) resources, and lower power consumption for HAD beamforming M-MIMO. It increases in the degrees of freedom in the DPD and, at the same time, more diversity in the basis functions.

Ideal input signals and the output of GD based adaptation for the MP model are complex and the complex data may be directly applied in the MP model. However, the ML model may naturally work with only with real-valued signals. Hence, it may firstly be necessary to convert a complex-valued first signal $x(n)$ into a real signal in a matrix format considering also memory stages in the ML model.

Additionally, the embodiments described herein may be considered to be low power and provide a high energy efficiency due to their simplicity, especially in the HAD beamforming M-MIMO embodiments.

This low power consumption and high energy efficiency may be because, instead of a single large-scale MP model with numerous polynomial terms and memory terms, the proposed approach increases the degrees of freedom in the modelling by employing GB based ML model, and at the same time, creates more diversity in the basis functions. Hence, the proposed ML assisted MP based method achieves very high modeling accuracy with less required memory (hardware) resource, as well as lower power consumption on HAD beamforming M-MIMO structure.

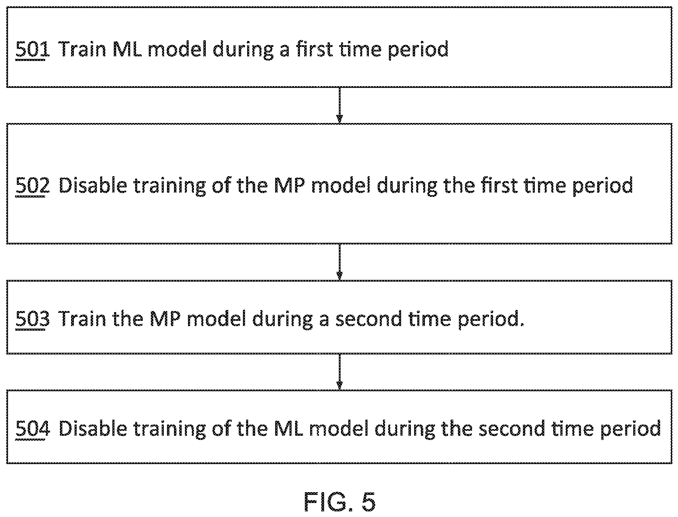

Figure 5 illustrates a method of training a combination model for performing digital predistortion to provide a transmit signal, $\breve{x}(n)$, wherein the transmit signal, $\breve{x}(n)$, is for deriving one or more amplifier signals, $\breve{x}_m(n)$, for driving one or more power amplifiers, wherein the one or more power amplifiers are associated with a respective one or more antenna elements. The combination model comprises a ML model and a MP model, for example as illustrated in Figure 4. It will be appreciated that the method of Figure 5 may be performed using online data, offline data, or a combination of both online data and offline data (as described above).

In step 501 the method comprises training ML model during a first time period.

In step 502 the method comprises disabling training of the MP model during the first time period.

In step 503 the method comprises training the MP model during a second time period.

In step 504 the method comprises disabling training of the ML model during the second time period.

The method of Figure 5 may further comprise receiving a feedback signal, y(n), based on an output of the one or more power amplifiers (for example as illustrated in Figures 2 and 4.

Similarly to as described above with reference to Figure 3, the method of Figure 5 may further comprise training the MP model and the ML model using the feedback signal $y(n)$ and a first signal $x(n)$ input into the combination model by performing periodic and alternate updates to the MP model and the ML model.

In some examples, the method of Figure 5 comprises triggering the start of the first time period in response to a request to update the ML model. In some examples, the method of Figure 5 comprises triggering the start of the second time period in response to a request to update the MP model.

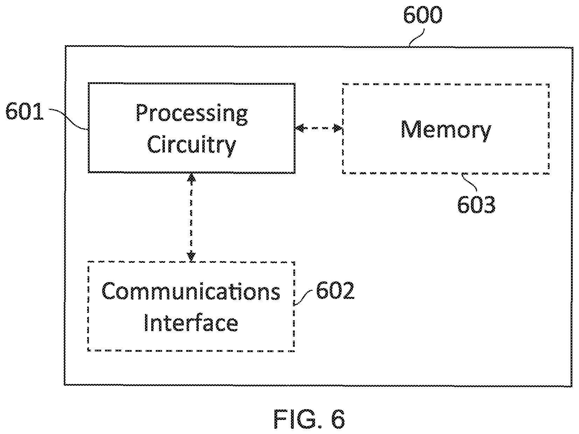

Figure 6 illustrates an DPD module 600 comprising processing circuitry (or logic) 601. The processing circuitry 601 controls the operation of the DPD module 600 and can implement the method described herein in relation to an DPD module 600. The processing circuitry 601 can comprise one or more processors, processing units, multi-core processors or modules that are configured or programmed to control the DPD module 600 in the manner described herein. In particular implementations, the processing circuitry 601 can comprise a plurality of software and/or hardware modules that are each configured to perform, or are for performing, individual or multiple steps of the method described herein in relation to the DPD module 600.

Briefly, the processing circuitry 601 of the DPD module 600 is configured to: receive a first signal, $x(n)$; and input the first signal $x(n)$ into a combination model, wherein the combination model comprises a machine learning, ML, model and a memory polynomial, MP, model; and output the transmit signal $\check{x}(n)$ from the combination model.

In some embodiments, the DPD module 600 may optionally comprise a communications interface 602. The communications interface 602 of the DPD module 600 can be for use in communicating with other nodes, such as other virtual nodes. For example, the communications interface 602 of the DPD module 600 can be configured to transmit to and/or receive from other nodes requests, resources, information, data, signals, or similar. The processing circuitry 601 of DPD module 600 may be configured to control the communications interface 602 of the DPD module 600 to transmit to and/or receive from other nodes requests, resources, information, data, signals, or similar.

Optionally, the DPD module 600 may comprise a memory 603. In some embodiments, the memory 603 of the DPD module 600 can be configured to store program code that can be executed by the processing circuitry 601 of the DPD module 600 to perform the method described herein in relation to the DPD module 600. Alternatively or in addition, the memory 603 of the DPD module 600, can be configured to store any requests, resources, information, data, signals, or similar that are described herein. The processing circuitry 601 of the DPD module 600 may be configured to control the memory 603 of the DPD module 600 to store any requests, resources, information, data, signals, or similar that are described herein.

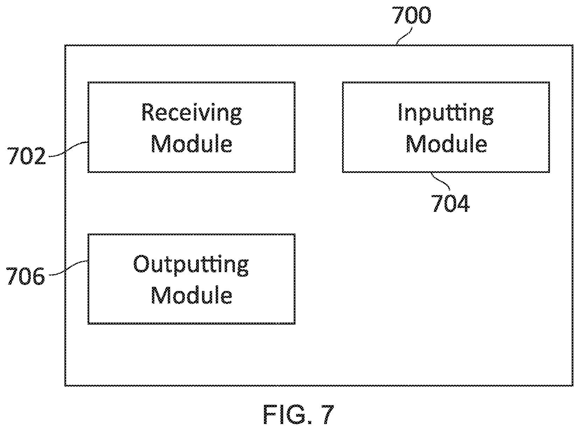

**Figure 7** is a block diagram illustrating an DPD module 700 according to some embodiments. The DPD module 700 can perform DPD to provide a transmit signal. The DPD module 700 comprises a receiving module 702 configured to receive a first signal $x(n)$. The DPD module 700 comprises an inputting module 704 configured to input the first signal $x(n)$ into a combination model, wherein the combination model comprises an ML model and an MP model. The DPD module 700 further comprises an outputting module 706 configured to output the transmit signal The DPD module 700 may operate in the manner described herein in respect of an DPD module.

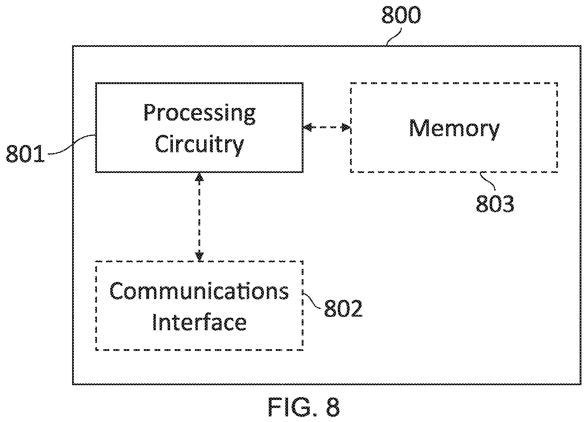

**Figure 8** illustrates an DPD module 800 comprising processing circuitry (or logic) 801. The processing circuitry 801 controls the operation of the DPD module 800 and can implement the method described herein in relation to an DPD module 800. The processing circuitry 801 can comprise one or more processors, processing units, multi-core processors or modules that are configured or programmed to control the DPD module 800 in the manner described herein. In particular implementations, the processing circuitry 801 can comprise a plurality of software and/or hardware modules that are each configured to perform, or are for performing, individual or multiple steps of the method described herein in relation to the DPD module 800.

Briefly, the processing circuitry 801 of the DPD module 800 is configured to: train the ML model during a first time period; disable training of the MP model during the first time period; train the MP model during a second time period; and disable training of the ML model during the second time period.

In some embodiments, the DPD module 800 may optionally comprise a communications interface 802. The communications interface 802 of the DPD module 800 can be for use in communicating with other nodes, such as other virtual nodes. For example, the communications interface 802 of the DPD module 800 can be configured to transmit to and/or receive from other nodes requests, resources, information, data, signals, or similar. The processing circuitry 801 of DPD module 800 may be configured to control the communications interface 802 of the DPD module 800 to transmit to and/or receive from other nodes requests, resources, information, data, signals, or similar.

Optionally, the DPD module 800 may comprise a memory 803. In some embodiments, the memory 803 of the DPD module 800 can be configured to store program code that can be executed by the processing circuitry 801 of the DPD module 800 to perform the method described herein in relation to the DPD module 800. Alternatively or in addition, the memory 803 of the DPD module 800, can be configured to store any requests, resources, information, data, signals, or similar that are described herein. The processing circuitry 801 of the DPD module 800 may be configured to control the memory 803 of the DPD module 800 to store any requests, resources, information, data, signals, or similar that are described herein.

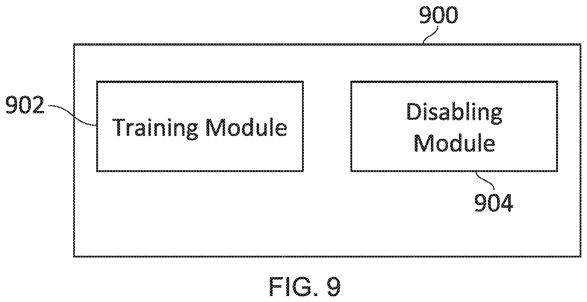

**Figure** 9 is a block diagram illustrating an DPD module 900 according to some embodiments. The DPD module 900 can perform training of a combination model to perform DPD. The DPD module 900 comprises a training module 902 configured to train the ML model during a first time period and train the MP model during a second time period. The DPD module 900 further comprises a disabling module 904 configured to disable training of the MP model during the first time period and disable training of the ML model during the second time period. The DPD module 900 may operate in the manner described herein in respect of an DPD module.

There is also provided a computer program comprising instructions which, when executed by processing circuitry (such as the processing circuitry 601 of the DPD module 600 described earlier), cause the processing circuitry to perform at least part of the method described herein. There is provided a computer program product, embodied on a non-transitory machine-readable medium, comprising instructions which are executable by processing circuitry to cause the processing circuitry to perform at least part of the method described herein. There is provided a computer program product comprising a carrier containing instructions for causing processing circuitry to perform at least part of the method described herein. In some embodiments, the carrier can be any one of an electronic signal, an optical signal, an electromagnetic signal, an electrical signal, a radio signal, a microwave signal, or a computer-readable storage medium.

Simulation Results

Embodiments described herein obtain robust DPD performance, particularly in conjunction with HAD beamforming M-MIMO structures under both static and dynamic traffic that would significantly reduce performance of traditional DPD methods.

Although MP models typically provide good performance in single antenna and/or small number of antenna structures considering one RX/TX chain, the performance of MP models significantly decreases when used in systems comprising a large number of antennas/M-MIMO structures in a single path with or without dynamic traffic.

The performance of DPD when utilising traditional polynomial based algorithms such as MP as the natural reference with a HAD beamforming M-MIMO structure is significantly degraded in terms of NMSE and ACEPR based on the results as seen in reference [4].

When only ML based DPD is considered as the base-line algorithm herein, the proposed ML assisted MP based DPD gives approximately 6 dB and 4 dB better performance in terms of NMSE under static and dynamic traffic, respectively.

Due to the good performance of our proposed algorithm under HAD beamforming M-MIMO structure, it may be considered unnecessary to implement digital beamforming M-MIMO for each TX chain with huge computational and hardware complexities.

The following sets out experimental results of a study into the performance of i) without DPD, ii) only ML based DPD, and iii) our proposed ML assisted MP based DPD.

Normalized individual power amplifier output spectra of 16 different power amplifier models are applied at a 120 MHz sample rate. The transmitted Orthogonal frequency-division multiplexing (OFDM) carrier is 20 MHz bandwidth and the Peak-to-average power ratio (PAPR) is 7.7 dB. To evaluate the performance of the different behavioral modeling techniques, NMSE and ACEPR are used. The NMSE evaluates the performance of different DPD compensation techniques, and may be defined as

$$\mathrm{NMSE}_{\mathrm{dB}} = 10\log_{10} \frac{\sum_{n=1}^{N}|e_{\mathrm{model}}[n]|^2}{\sum_{n=1}^{N}|y_{\mathrm{meas}}[n]|^2}$$

where $e_{\mathrm{model}}[n] = y_{\mathrm{meas}}[n] - y_{\mathrm{model}}[n]$ is the error signal between a measured signal and a predicted signal. On the other hand, ACEPR evaluates only the out-of-band modeling performance, computing a ratio between the error signal power over an adjacent channel and a desired channel power of the measured signal ( $P_{\mathrm{error}}^{\mathrm{adj}}$ and $P_{\mathrm{meas}}^{\mathrm{ch}}$ ), as

$$\text{ACEPR}_{\text{dB}} = 10\log_{10}\frac{P_{\text{error}}^{\text{adj}}}{P_{\text{meas}}^{\text{ch}}}.$$

The training networks of ML (specifically GB) based methods are applied once and saved for the future test signals. In the data processing stage, the different training and test datasets are considered with the total number of samples N = 100 000.

It is noted that when dynamic traffic is considered as an example of 10 different power levels, each data portion includes 10 000 number of samples. The main reason for this process is to capture two uncorrelated datasets as if there is a strong correlation between training and test data, the performance of the DPD will be inaccurate.

In the proposed ML (specifically GB) assisted MP based DPD on HAD beamforming M-MIMO algorithms, the maximum depth of 100 and 1000 number of estimators are chosen with 0.01 learning rate considering memory order M = 4 in the GB regression part. For the MP part, a polynomial order of P = 7 is used (with odd orders only considered) and a memory order of M = 4. For the base-line algorithm to have fair comparison, the same parameters are considered for only the ML based DPD method. Once the training stage is completed, the different test signals are applied in the prediction stage using the saved fitting network. Finally, the NMSE and ACEPR are calculated after forming the complex signals from the real-valued predictor outputs.

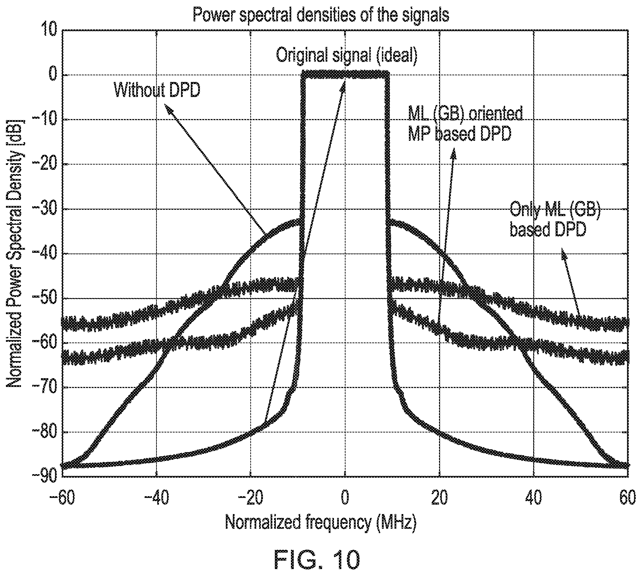

**Figure 10** illustrates normalised power spectral density as a function of frequency for signals without DPD, with ML assisted MP based DPD, and with only ML based DPD under static traffic conditions.

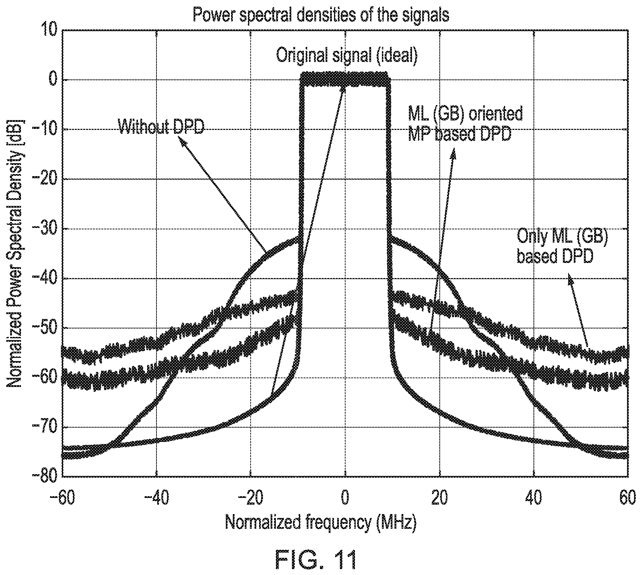

**Figure 11** illustrates normalised power spectral density as a function of frequency for signals without DPD, with ML assisted MP based DPD, and with only ML based DPD under dynamic traffic conditions.

As seen in both Figure 10 (under static traffic as a more idealistic environment) and Figure 11 (under dynamic traffic as a more realistic environment), there is significant performance degradation on nonlinearity compensations considering only GB based DPD out-of-band (adjacent channel) parts. On the contrary, the proposed GB assisted MP based DPD approach under HAD beamforming M-MIMO significantly gives performance improvement. As natural, dynamic traffic decreases the performance of all algorithms compared to the static traffic. However, the proposed approach still gives reasonably good performance under dynamic traffic as well. The numerical values for both NMSE and ACEPR are given in details in the following Table I and Table II.

TABLE I: NMSE AND ACEPR OF ML AND POLYNOMIAL BASED ALGORITHMS FOR THE BASE STATION POWER AMPLIFIER USING THE STATIC TRAFFIC.

| Machine Learning and Polynomial based Algorithms | NMSE | ACEPR |
|---|---|---|
| Without DPD | -29.5342 | -37.7095 |
| With ML (GB) based DPD | -40.1015 | -46.6949 |
| With ML (GB) aided MP based DPD | **-46.0607** | **-54.8728** |

TABLE II: NMSE AND ACEPR OF ML AND POLYNOMIAL BASED ALGORITHMS FOR THE BASE STATION POWER AMPLIFIER USING THE DYNAMIC TRAFFIC.

| Machine Learning and Polynomial based Algorithms | NMSE | ACEPR |
|---|---|---|
| Without DPD | -28.6704 | -37.0850 |
| With ML (GB) based DPD | -37.8501 | -44.7948 |
| With ML (GB) aided MP based DPD | **-41.6598** | **-50.4569** |

Herein, two cases as "a single power level near to the saturation level of PA" and "a single predictor at 10 different output power levels of PA" are considered to evaluate the performance of the learning techniques under HAD beamforming M-MIMO structure as seen in Table I and Table II, respectively. Consideration of a HAD beamforming M-MIMO structure together with the single predictor decreases the computational complexity significantly compared to fully digital beamforming M-MIMO structure which includes DPD for each antenna.

It is noted that one NMSE and one ACEPR values are shown in Table I and Table II for the proposed and base-line (reference) method that the single predictor is applied to obtain the performance under either static or combination/merging of ten different power levels considering HAD beamforming M-MIMO. Based on the results in Table I and Table II, GB assisted MP based DPD approach gives significantly better performance than the reference only GB based approach under both static and dynamic traffic.

It can be seen from Table I and Table II that, while the NMSE performances of the only GB based DPD under static and dynamic are **-40.10 dB** and **-37.85 dB,** respectively, NMSE performances of proposed GB assisted MP based DPD under static traffic and dynamic traffic are **-46.06** dB and **-41.66 dB,** respectively. Similarly, while the ACEPR performances of the only GB based DPD under static and dynamic traffic are **-46.69 dB** and **-44.79 dB,** respectively, ACEPR performances of proposed GB assisted MP based DPD under static traffic and dynamic traffic are **-54.87** dB and **-50.45 dB,** respectively.

As a conclusion, the proposed ML specifically GB assisted MP based DPD gives ap approximately **5dB** (average) performance improvement compared to only GB based DPD in terms of NMSE. Similarly, there are approximately **6 dB** (average) performance improvements in terms of ACEPR considering the proposed approach compared to only GB based DPD as seen in the same tables.

The proposed ML assisted MP based DPD on HAD M-MIMO beamforming has below advantages: Improved performance under both static and dynamic traffic and under this structure where almost no performance degradation is observed on the performances of both NMSE and ACEPR.

Noteworthy, the performance of the base-line algorithms such as only ML based DPD gives 6 dB and 4 dB worse performance in terms of NMSE compared to the embodiments described herein (under static and dynamic traffic, respectively).

Additionally, the embodiments described herein give 8 dB and 6 dB better performance in terms of ACEPR compared to base-line only ML based approach under static and dynamic traffic, respectively.

This high performance may boost the application of HAD beamforming M-MIMO structure with less computational and hardware complexity. On the contrary, to keep the same performances in the base-line algorithms such as only MP and only ML, it may be required to have extra processes that includes huge computational complexity and the memory resources on HAD beamforming M-MIMO.

Additionally, while traditional DPD approaches in fully digital beamforming structure include higher degree of freedom resulting with the good performance, the implementation of DPD on digital beamforming M-MIMO structure requires huge computational and hardware complexities compared to DPD on HAD beamforming M-MIMO structure.

Embodiments described herein allow for easy deployment. For example, two approaches may be applied to radio products with affordable effort. First, offline training and online prediction may be applied. The training may be performed in the production line with pre-defined training data. Then the resultant trees may be stored in a database. Since the prediction usually does not need high computation, this approach may minimize the cost of the application. Second, online training and online prediction may be performed. The training may then be performed periodically based on the data provided by the observation path. In this case, the training may follow the state of power amplifier and may extract state-of-the-art behavior. To reduce the computation, it may be possible to lengthen the periodicity, or decrease the scale of trees.

Embodiments described herein also improve energy efficiency and lessen power consumption. For example, the as illustrated in the simulation results above, the ML assisted MP based DPD on HAD beamforming M-MIMO improves the energy efficiency in the structure. Furthermore, with the possibility of the offline training implementation this means that efficiency can be further improved as the repeating of the training may not be required if the environment does not often change.

## Reference List

1. E. G. Larsson, O. Edfors, F. Tufvesson, and T. L. Marzetta, "Massive MIMO for next generation wireless systems," IEEE Commun. Mag., vol. 52, no. 2, pp. 186-195, Feb. 2014.

2. F. Boccardi, R. W. Heath, A. Lozano, T. L. Marzetta, and P. Popovski, "Five disruptive technology directions for 5G," IEEE Commun. Mag., vol. 52, no. 2, pp. 74-80, Feb. 2014.

3. A. F. Molisch et al., "Hybrid beamforming for massive MIMO: A survey," IEEE Commun. Mag., vol. 55, no. 9, pp. 134-141, Sep. 2017.

4. M. Abdelaziz, L. Anttila, A. Brihuega, F. Tufvesson and M. Valkama, "Digital predistortion for hybrid MIMO transmitters," in IEEE Journal of Selected Topics in Signal Processing, vol. 12, no. 3, pp. 445-454, June 2018, doi: 10.1109/JSTSP.2018.2824981.

5. E. Bjornson, J. Hoydis, M. Kountouris, and M. Debbah, "Massive MIMO systems with non-ideal hardware: Energy efficiency, estimation, and capacity limits," IEEE Trans. Inf. Theory, vol. 60, no. 11, pp. 7112-7139, Nov. 2014.

6. D. R. Morgan et al., "A generalized memory polynomial model for digital predistortion of RF power amplifiers," IEEE Trans. Signal Process., vol. 54, no. 10, pp. 3852-3860, 2006.

7. Sheppard, "Tree-based machine learning algorithms: Decision trees, random forests, and boosting" CreateSpace Ind. Publish. Platform, 2017.

8. J. Song, J. Zhao, F. Dong, J. Zhao, Z. Qian, and Q. Zhang, "A novel regression modeling method for PMSLM structural design optimization using a distance-weighted KNN algorithm," IEEE Transactions on Industry Applications, vol. 54, no. 5, pp. 4198-4206, Sep. 2018.

9. M. A. Nielsen, "Neural networks and deep learning" Determination Press, 2018.

10. S. Dikmese, L. Anttila, P. Pascual Campo, M. Valkama and M. Renfors, "Behavioral modeling of power amplifiers with modern machine learning techniques," IEEE MTT-S International Microwave Conference on Hardware and Systems for 5G and Beyond, Atlanta, GA, USA, August 2019.

11. C. Mollen, U. Gustavsson, T. Eriksson, and E. G. Larsson, "Out-of-band radiation measure for MIMO arrays with beamformed transmission," in Proc. IEEE Int. Conf. Commun., May 2016, pp. 1-6.

12. J. Shen, S. Suyama, T. Obara, and Y. Okumura, "Requirements of power amplifier on super high bit rate massive MIMO OFDM transmission using higher frequency bands," in Proc. IEEE Globecom Workshops, Dec. 2014, pp. 433-437.

13. Y. Zou et al., "Impact of power amplifier nonlinearities in multi-user massive MIMO downlink," in Proc. IEEE Globecom Workshops, Dec. 2015, pp. 1-7.

14. C. Mollen, E. G. Larsson, U. Gustavsson, T. Eriksson and R. W. Heath, "Out-of-band radiation from large antenna arrays," in IEEE Communications Magazine, vol. 56, no. 4, pp. 196-203, April 2018, doi: 10.1109/MCOM.2018.1601063.

15. Y. Guo, C. Yu and A. Zhu, "Power adaptive digital predistortion for wideband RF power amplifiers with dynamic power transmission," IEEE Trans. Microw. Theory Techn., vol. 63. No. 11, pp. 1-13. 2015.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single processor or other unit may fulfil the functions of several units recited in the claims. Any reference signs in the claims shall not be construed so as to limit their scope.

**Claims**

1. A method of performing digital predistortion, DPD, to provide a transmit signal, $\check{x}(n)$ wherein the transmit signal, $\check{x}(n)$, is for deriving one or more amplifier signals, $\check{x}_m(n)$, for driving one or more power amplifiers, wherein the one or more power amplifiers are associated with a respective one or more antenna elements, the method comprising:

   receiving (301) a first signal, $x(n)$;
   inputting (302) the first signal, $x(n)$, into a combination model, wherein the combination model comprises a machine learning, ML, model and a memory polynomial, MP, model,
   and the MP model is configured to receive an output of the ML model or the ML model is configured to receive an output of the MP model;
   outputting (303) the transmit signal $\check{x}(n)$, from the combination model;
   receiving a feedback signal, y(n), based on an output of the one or more power amplifiers;

   the method being **characterised by** further comprising:

   during a first time period performing training of the ML model using the feedback signal, $y(n)$ and the first signal $x(n)$;
   during the first time period disabling training of the MP model;
   during a second time period performing training of the MP model using the feedback signal, $y(n)$ and the first signal $x(n)$; and
   during the second time period disabling training of the ML model.

2. The method as claimed in 1 comprising:
   training the MP model and the ML model using the feedback signal y(n) by performing periodic and alternate updates to the MP model and the ML model.

3. The method as claimed in claim 1 comprising:
   triggering the start of the first time period in response to a request to update the ML model.

4. The method as claimed in any preceding claim wherein the transmit signal, $\check{x}(n)$, is for deriving a plurality of amplifier signals $\check{x}_m(n)$.

**5.** The method as claimed in claim 1 comprising:
deriving the plurality of amplifier signals $\check{x}_m(n)$ by inputting the transmit signal, $\check{x}(n)$, into an analog beamforming module.

**6.** The method as claimed in claim 1 wherein the transmit signal $\check{x}(n)$, is for deriving one amplifier signal $\check{x}_m(n)$ and $\check{x}_m(n) = \check{x}(n)$.

**7.** A method of training a combination model for performing digital predistortion on a first signal x(n) input into the combination model to provide a transmit signal, $\check{x}(n)$ wherein the transmit signal, $\check{x}(n)$, is for deriving one or more amplifier signals, $\check{x}_m(n)$, for driving one or more power amplifiers, wherein the one or more power amplifiers are associated with a respective one or more antenna elements, wherein the combination model comprises a machine learning, ML, model and a memory polynomial, MP, model, and the MP model is configured to receive an output of the ML model or the ML model is configured to receive an output of the MP model, the method comprising:
receiving a feedback signal, y(n), based on an output of the one or more power amplifiers;
the method being **characterised by** further comprising:

> training (501) the ML model during a first time period using the feedback signal y(n) and the first signal x(n);
> disabling (502) training of the MP model during the first time period;
> training (503) the MP model during a second time period using the feedback signal y(n) and the first signal x(n);
> disabling (504) training of the ML model during the second time period.

**8.** A DPD module (600, 700, 800) for performing digital predistortion, DPD, to provide a transmit signal, $\check{x}(n)$ wherein the transmit signal, $\check{x}(n)$, is for deriving one or more amplifier signals, $\check{x}_m(n)$, for driving one or more power amplifiers wherein the one or more power amplifiers are associated with a respective one or more antenna elements, the DPD module comprising processing circuitry configured to:

> receive (301) a first signal, $x(n)$; and
> input (302) the first signal $x(n)$ into a combination model, wherein the combination model comprises a machine learning, ML, model and a memory polynomial, MP, model and the MP model is configured to receive an output of the ML model or the ML model is configured to receive an output of the MP model; and
> output (303) the transmit signal $\check{x}(n)$ from the combination model;
> receive a feedback signal, y(n), based on an output of the one or more power amplifiers;

**characterised in that** the processing circuitry is further configured to:

> during a first time period perform training of the ML model using the feedback signal, $y(n)$ and the first signal $x(n)$;
> during the first time period disable training of the MP model;
> during a second time period perform training of the MP model using the feedback signal, $y(n)$ and the first signal $x(n)$; and
> during the second time period disable training of the ML model.

**9.** The DPD module (600, 700, 800) as claimed in claim 8 wherein the processing circuitry is configured to cause the DPD module to perform the method as claimed in any one of claims 2 to 6.

**10.** A DPD module (600, 700, 800) for training a combination model to perform digital predistortion, DPD, on a first signal x(n) input into the combination model to provide a transmit signal, $\check{x}(n)$ wherein the transmit signal, $\check{x}(n)$, is for deriving one or more amplifier signals, $\check{x}_m(n)$, for driving one or more power amplifiers, wherein the one or more power amplifiers are associated with a respective one or more antenna elements, wherein the combination module comprises a machine learning, ML, model and a memory polynomial, MP, model, and the MP model is configured to receive an output of the ML model or the ML model is configured to receive an output of the MP model, the DPD module comprising processing circuitry configured to:
receive a feedback signal, y(n), based on an output of the one or more power amplifiers;
**characterised in that** the processing circuitry is further configured to:

> train (501) the ML model during a first time period using the feedback signal y(n) and the first signal x(n);
> disable (502) training of the MP model during the first time period;
> train (503) the MP model during a second time period using the feedback signal y(n) and the first signal x(n);
> disable (504) training of the ML model during the second time period.

11. A beamforming module for performing digital predistortion, DPD, the beamforming module comprising a DPD module (600, 700, 800) as claimed in one of claims 8 to 10.

12. The beamforming module as claimed in claim 11 wherein the beamforming module comprises a HAD MIMO beamforming module.

13. The beamforming module as claimed in claim 11 wherein the beamforming module comprises a digital beamforming module.

14. A computer program comprising instructions which, when executed on at least one processor, cause the at least one processor to carry out a method according to any of claims 1 to 7.

15. A computer program product comprising non transitory computer readable media having stored thereon a computer program according to claim 14.

**Patentansprüche**

1. Verfahren zur Durchführung digitaler Vorverzerrung, DPD, um ein Sendesignal $\check{x}(n)$ bereitzustellen, wobei das Sendesignal $\check{x}(n)$ zum Ableiten eines oder mehrerer Verstärkersignale $\check{x}_m(n)$ zum Ansteuern eines oder mehrerer Leistungsverstärker ist, wobei der eine oder die mehreren Leistungsverstärker mit einem oder mehreren jeweiligen Antennenelementen assoziiert sind, wobei das Verfahren Folgendes umfasst:

Empfangen (301) eines ersten Signals **x(n)**;
Eingeben (302) des ersten Signals **x(n)** in ein Kombinationsmodell, wobei das Kombinationsmodell ein Modell für maschinelles Lernen, ML, und ein Speicher-Polynom-Modell, MP-Modell, umfasst und das MP-Modell dazu konfiguriert ist, eine Ausgabe des ML-Modells zu empfangen, oder das ML-Modell dazu konfiguriert ist, eine Ausgabe des MP-Modells zu empfangen;
Ausgeben (303) des Sendesignals $\check{x}(n)$ aus dem Kombinationsmodell;
Empfangen eines Rückmeldungssignals **y(n)** basierend auf einer Ausgabe des einen oder der mehreren Leistungsverstärker;
wobei das Verfahren **dadurch gekennzeichnet ist, dass** es ferner Folgendes umfasst:

während eines ersten Zeitraums Durchführen von Training des ML-Modells unter Verwendung des Rückmeldungssignals **y(n)** und des ersten Signals **x(n)**;
während des ersten Zeitraums Deaktivieren des Trainings des MP-Modells;
während eines zweiten Zeitraums Durchführen von Training des MP-Modells unter Verwendung des Rückmeldungssignals **y(n)** und des ersten Signals *x(n)*; und
während des zweiten Zeitraums Deaktivieren des Trainings des ML-Modells.

2. Verfahren nach Anspruch 1, umfassend:
Trainieren des MP-Modells und des ML-Modells unter Verwendung des Rückmeldungssignals *y(n)* durch Durchführen periodischer und abwechselnder Aktualisierungen an dem MP-Modell und dem ML-Modell.

3. Verfahren nach Anspruch 1, umfassend:
Auslösen des Starts des ersten Zeitraums in Reaktion auf eine Anforderung zum Aktualisieren des ML-Modells.

4. Verfahren nach einem der vorhergehenden Ansprüche, wobei das Sendesignal $\check{x}(n)$ zum Ableiten einer Mehrzahl von Verstärkersignalen $\check{x}_m(n)$ ist.

5. Verfahren nach Anspruch 1, umfassend:
Ableiten der Mehrzahl von Verstärkersignalen $\check{x}_m(n)$ durch Eingeben des Sendesignals $\check{x}(n)$ in eine analoges Strahlformungsmodul.

6. Verfahren nach Anspruch 1, wobei das Sendesignal $\check{x}(n)$ zum Ableiten eines Verstärkersignals $\check{x}_m(n)$ ist und $\check{x}_m(n) = \check{x}(n)$ ist.

7. Verfahren zum Trainieren eines Kombinationsmodells zum Durchführen digitaler Vorverzerrung an einem ersten

Signal $\check{x}(n),$ das in das Kombinationsmodell eingegeben wird, um ein Sendesignal $\check{x}(n)$ bereitzustellen, wobei das Sendesignal $\check{x}(n)$ zum Ableiten eines oder mehrerer Verstärkersignale $\check{x}_m(n)$ zum Ansteuern eines oder mehrerer Leistungsverstärker ist, wobei der eine oder die mehreren Leistungsverstärker mit einem oder mehreren jeweiligen Antennenelementen assoziiert sind, wobei das Kombinationsmodell ein Modell für maschinelles Lernen, ML, und ein Speicher-Polynom-Modell, MP-Modell, umfasst und das MP-Modell dazu konfiguriert ist, eine Ausgabe des ML-Modells zu empfangen, und das ML-Modell dazu konfiguriert ist, eine Ausgabe des MP-Modells zu empfangen, wobei das Verfahren Folgendes umfasst:

Empfangen eines Rückmeldungssignals $y(n)$ basierend auf einer Ausgabe des einen oder der mehreren Leistungsverstärker;
wobei das Verfahren **dadurch gekennzeichnet ist, dass** es ferner Folgendes umfasst:
Trainieren (501) des ML-Modells während eines ersten Zeitraums unter Verwendung des Rückmeldungssignals \y(n) und des ersten Signals $x(n);$
Deaktivieren (502) des Trainings des MP-Modells während des ersten Zeitraums;
Trainieren (503) des MP-Modells während eines zweiten Zeitraums unter Verwendung des Rückmeldungssignals $y(n)$ und des ersten Signals $x(n);$
Deaktivieren (504) des Trainings des ML-Modells während des zweiten Zeitraums.

**8.** DPD-Modul (600, 700, 800) zum Durchführen digitaler Vorverzerrung, DPD, um ein Sendesignal $\check{x}(n)$ bereitzustellen, wobei das Sendesignal $\check{x}(n)$ zum Ableiten eines oder mehrerer Verstärkersignale $\check{x}_m(n)$ zum Ansteuern eines oder mehrerer Leistungsverstärker ist, wobei der eine oder die mehreren Leistungsverstärker mit einem oder mehreren jeweiligen Antennenelementen assoziiert sind, wobei das DPD-Modul Verarbeitungsschaltungsanordnung umfasst, die zu Folgendem konfiguriert ist:

Empfangen (301) eines ersten Signals $x(n);$ und
Eingeben (302) des ersten Signals $x(n)$ in ein Kombinationsmodell, wobei das Kombinationsmodell ein Modell für maschinelles Lernen, ML, und ein Speicher-Polynom-Modell, MP-Modell umfasst und das MP-Modell dazu konfiguriert ist, eine Ausgabe des ML-Modells zu empfangen, oder das ML-Modell dazu konfiguriert ist, eine Ausgabe des MP-Modells zu empfangen; und
Ausgeben (303) des Sendesignals $\check{x}(n)$ aus dem Kombinationsmodell;
Empfangen eines Rückmeldungssignals $y(n)$ basierend auf einer Ausgabe des einen oder der mehreren Leistungsverstärker;
**dadurch gekennzeichnet, dass** die Verarbeitungsschaltungsanordnung ferner zu Folgendem konfiguriert ist:

während eines ersten Zeitraums Durchführen von Training des ML-Modells unter Verwendung des Rückmeldungssignals $y(n)$ und des ersten Signals $x(n);$
während des ersten Zeitraums Deaktivieren des Trainings des MP-Modells;
während eines zweiten Zeitraums Durchführen von Training des MP-Modells unter Verwendung des Rückmeldungssignals $y(n)$ und des ersten Signals $x(n);$
und
während des zweiten Zeitraums Deaktivieren des Trainings des ML-Modells.

**9.** DPD-Modul (600, 700, 800) nach Anspruch 8, wobei die Verarbeitungsschaltungsanordnung ferner dazu konfiguriert ist, das DPD-Modul zum Durchführen des Verfahrens nach einem der Ansprüche 2 bis 6 zu veranlassen.

**10.** DPD-Modul (600, 700, 800) zum Trainieren eines Kombinationsmodells zum Durchführen digitaler Vorverzerrung, DPD, an einem ersten Signal $x(n),$ das in das Kombinationsmodell eingegeben wird, um ein Sendesignal $\check{x}(n)$ bereitzustellen, wobei das Sendesignal $\check{x}(n)$ zum Ableiten eines oder mehrerer Verstärkersignale $\check{x}_m(n)$ zum Ansteuern eines oder mehrerer Leistungsverstärker ist, wobei der eine oder die mehreren Leistungsverstärker mit einem oder mehreren jeweiligen Antennenelementen assoziiert sind, wobei das Kombinationsmodul ein Modell für maschinelles Lernen, ML, und ein Speicher-Polynom-Modell, MP-Modell, umfasst und das MP-Modell dazu konfiguriert ist, eine Ausgabe des ML-Modells zu empfangen, und das ML-Modell dazu konfiguriert ist, eine Ausgabe des MP-Modells zu empfangen, wobei das DPD-Modul Verarbeitungsschaltungsanordnung umfasst, die zu Folgendem konfiguriert ist:

Empfangen eines Rückmeldungssignals $y(n)$ basierend auf einer Ausgabe des einen oder der mehreren Leistungsverstärker;
**dadurch gekennzeichnet, dass** die Verarbeitungsschaltungsanordnung ferner zu Folgendem konfiguriert ist:

EP 4 595 210 B1

Trainieren (501) des ML-Modells während eines ersten Zeitraums unter Verwendung des Rückmeldungssignals **y(n)** und des ersten Signals **x(n);**
Deaktivieren (502) des Trainings des MP-Modells während des ersten Zeitraums;
Trainieren (503) des MP-Modells während eines zweiten Zeitraums unter Verwendung des Rückmeldungssignals **y(n)** und des ersten Signals **x(n);**
Deaktivieren (504) des Trainings des ML-Modells während des zweiten Zeitraums.

11. Strahlformungsmodul zum Durchführen digitaler Vorverzerrung, DPD, wobei das Strahlformungsmodul ein DPD-Modul (600, 700, 800) nach einem der Ansprüche 8 bis 10 umfasst.

12. Strahlformungsmodul nach Anspruch 11, wobei das Strahlformungsmodul ein HAD-MIMO-Strahlformungsmodul umfasst.

13. Strahlformungsmodul nach Anspruch 11, wobei das Strahlformungsmodul ein digitales Strahlformungsmodul umfasst.

14. Computerprogramm, umfassend Anweisungen, die bei Ausführung auf mindestens einem Prozessor den mindestens einen Prozessor zum Durchführen eines Verfahrens nach einem der Ansprüche 1 bis 7 veranlassen.

15. Computerprogrammprodukt, umfassend nichttransitorische computerlesbare Medien, die ein Computerprogramm nach Anspruch 14 darauf gespeichert aufweisen.


**Revendications**

1. Procédé de réalisation d'une prédistorsion numérique, DPD, pour fournir un signal de transmission, $\check{x}(n)$, dans lequel le signal de transmission, $\check{x}(n)$, est destiné à dériver un ou plusieurs signaux d'amplificateur, $\check{x}_m(n)$, pour commander un ou plusieurs amplificateurs de puissance, dans lequel les un ou plusieurs amplificateurs de puissance sont associés à un ou plusieurs éléments d'antennes respectifs, le procédé comprenant :

la réception (301) d'un premier signal, $x(n)$;
l'entrée (302) du premier signal, $x(n)$, dans un modèle de combinaison, dans lequel le modèle de combinaison comprend un modèle d'apprentissage automatique, ML, et un modèle de polynôme mémoire, MP, et le modèle MP est configuré pour recevoir une sortie du modèle ML ou le modèle ML est configuré pour recevoir une sortie du modèle MP ;
la délivrance (303) du signal de transmission, $\check{x}(n)$, depuis le modèle de combinaison ;
la réception d'un signal de retour, y(n), sur la base d'une sortie des un ou plusieurs amplificateurs de puissance ;
le procédé étant **caractérisé en ce qu'**il comprend en outre :

au cours d'une première période de temps, la réalisation d'un entraînement du modèle ML à l'aide du signal de retour, $y(n)$, et du premier signal, $x(n)$ ;
au cours de la première période de temps, la désactivation de l'entraînement du modèle MP ;
au cours d'une deuxième période de temps, la réalisation d'un entraînement du modèle MP à l'aide du signal de retour, $y(n)$, et du premier signal, $x(n)$; et
au cours de la deuxième période de temps, la désactivation de l'entraînement du modèle ML.

2. Procédé selon la revendication 1, comprenant :
l'entraînement du modèle MP et du modèle ML à l'aide du signal de retour, y(n), par la réalisation de mises à jour périodiques et alternées du modèle MP et du modèle ML.

3. Procédé selon la revendication 1, comprenant :
le déclenchement du début de la première période de temps en réponse à une demande de mise à jour du modèle ML.

4. Procédé selon l'une quelconque des revendications précédentes, dans lequel le signal de transmission, $\check{x}(n)$, est destiné à dériver une pluralité de signaux d'amplificateur, $\check{x}_m(n)$.

5. Procédé selon la revendication 1, comprenant :
la dérivation de la pluralité de signaux d'amplificateur, $\check{x}_m(n)$, par l'entrée du signal de transmission, $\check{x}(n)$, dans un module de formation de faisceau analogique.

6. Procédé selon la revendication 1, dans lequel le signal de transmission, $\check{x}(n)$, est destiné à dériver un signal d'amplificateur, $\check{x}_m(n)$, et $\check{x}_m(n) = \check{x}(n)$.

7. Procédé d'entraînement d'un modèle de combinaison pour réaliser une prédistorsion numérique sur un premier signal, $x(n)$, entré dans le modèle de combinaison pour fournir un signal de transmission, $\check{x}(n)$, dans lequel le signal de transmission, $\check{x}(n)$, est destiné à dériver un ou plusieurs signaux d'amplificateur, $\check{x}_m(n)$, pour commander un ou plusieurs amplificateurs de puissance, dans lequel les un ou plusieurs amplificateurs de puissance sont associés à un ou plusieurs éléments d'antennes respectifs, dans lequel le modèle de combinaison comprend un modèle d'apprentissage automatique, ML, et un modèle de polynôme mémoire, MP, et le modèle MP est configuré pour recevoir une sortie du modèle ML ou le modèle ML est configuré pour recevoir une sortie du modèle MP, le procédé comprenant :

la réception d'un signal de retour, $y(n)$, sur la base d'une sortie des un ou plusieurs amplificateurs de puissance ;
le procédé étant **caractérisé en ce qu'**il comprend en outre :

l'entraînement (501) du modèle ML au cours d'une première période de temps à l'aide du signal de retour, $y(n)$, et du premier signal, $x(n)$ ;
la désactivation (502) de l'entraînement du modèle MP au cours de la première période de temps ;
l'entraînement (503) du modèle MP au cours d'une deuxième période de temps à l'aide du signal de retour, $y(n)$, et du premier signal, $x(n)$ ;
la désactivation (504) de l'entraînement du modèle ML au cours de la deuxième période de temps.

8. Module DPD (600, 700, 800) pour réaliser une prédistorsion numérique, DPD, pour fournir un signal de transmission, $\check{x}(n)$, dans lequel le signal de transmission, $\check{x}(n)$, est destiné à dériver un ou plusieurs signaux d'amplificateur, $\check{x}_m(n)$, pour commander un ou plusieurs amplificateurs de puissance, dans lequel les un ou plusieurs amplificateurs de puissance sont associés à un ou plusieurs éléments d'antennes respectifs, le module DPD comprenant une circuiterie de traitement configurée pour :

recevoir (301) un premier signal, $x(n)$; et
entrer (302) le premier signal, $x(n)$, dans un modèle de combinaison, dans lequel le modèle de combinaison comprend un modèle d'apprentissage automatique, ML, et un modèle de polynôme mémoire, MP, et le modèle MP est configuré pour recevoir une sortie du modèle ML ou le modèle ML est configuré pour recevoir une sortie du modèle MP ; et
délivrer (303) le signal de transmission, $\check{x}(n)$, depuis le modèle de combinaison ;
recevoir un signal de retour, $y(n)$, sur la base d'une sortie des un ou plusieurs amplificateurs de puissance ;
**caractérisé en ce que** la circuiterie de traitement est en outre configurée pour :

au cours d'une première période de temps, réaliser un entraînement du modèle ML à l'aide du signal de retour, $y(n)$, et du premier signal, $x(n)$ ;
au cours de la première période de temps, désactiver l'entraînement du modèle MP ;
au cours d'une deuxième période de temps, réaliser un entraînement du modèle MP à l'aide du signal de retour, $y(n)$, et du premier signal, $x(n)$; et
au cours de la deuxième période de temps, désactiver l'entraînement du modèle ML.

9. Module DPD (600, 700, 800) selon la revendication 8, dans lequel la circuiterie de traitement est configurée pour amener le module DPD à réaliser le procédé selon l'une quelconque des revendications 2 à 6.

10. Module DPD (600, 700, 800) pour entraîner un modèle de combinaison pour réaliser une prédistorsion numérique, DPD, sur un premier signal, $x(n)$, entré dans le modèle de combinaison pour fournir un signal de transmission, $\check{x}(n)$, dans lequel le signal de transmission, $\check{x}(n)$, est destiné à dériver un ou plusieurs signaux d'amplificateur, $\check{x}_m(n)$, pour commander un ou plusieurs amplificateurs de puissance, dans lequel les un ou plusieurs amplificateurs de puissance sont associés à un ou plusieurs éléments d'antennes respectifs, dans lequel le modèle de combinaison comprend un modèle d'apprentissage automatique, ML, et un modèle de polynôme mémoire, MP, et le modèle MP est configuré pour recevoir une sortie du modèle ML ou le modèle ML est configuré pour recevoir une sortie du modèle MP, le module DPD comprenant une circuiterie de traitement configurée pour :

recevoir un signal de retour, y(n), sur la base d'une sortie des un ou plusieurs amplificateurs de puissance ;
**caractérisé en ce que** la circuiterie de traitement est en outre configurée pour :

entraîner (501) le modèle ML au cours d'une première période de temps à l'aide du signal de retour, $y(n)$, et du premier signal, $x(n)$ ;
désactiver (502) l'entraînement du modèle MP au cours de la première période de temps ;
entraîner (503) le modèle MP au cours d'une deuxième période de temps à l'aide du signal de retour, $y(n)$, et du premier signal, $x(n)$ ;
désactiver (504) l'entraînement du modèle ML au cours de la deuxième période de temps.

11. Module de formation de faisceau pour réaliser une prédistorsion numérique, DPD, le module de formation de faisceau comprenant un module DPD (600, 700, 800) selon l'une des revendications 8 à 10.

12. Module de formation de faisceau selon la revendication 11, dans lequel le module de formation de faisceau comprend un module de formation de faisceau HAD MIMO.

13. Module de formation de faisceau selon la revendication 11, dans lequel le module de formation de faisceau comprend un module de formation de faisceau numérique.

14. Programme informatique comprenant des instructions qui, lorsqu'elles sont exécutées sur au moins un processeur, amènent l'au moins un processeur à réaliser un procédé selon l'une quelconque des revendications 1 à 7.

15. Produit de programme informatique comprenant un support non transitoire lisible par ordinateur sur lequel est stocké un programme informatique selon la revendication 14.

FIG. 1a

EP 4 595 210 B1

FIG. 1b

FIG. 2

301 Receive a first signal

302 Input the first signal into a combination model, wherein the combination model comprises a machine learning, ML, model and a memory polynomial, MP, model

303 Output the transmit signal from the combination model.

FIG. 3

FIG. 4

501 Train ML model during a first time period

502 Disable training of the MP model during the first time period

503 Train the MP model during a second time period.

504 Disable training of the ML model during the second time period

FIG. 5

FIG. 6

FIG. 7

FIG. 8

900

902

Training Module

Disabling
Module

904

FIG. 9

FIG. 10

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Hybrid Digital Pre-Distortion for Active Phased Arrays Subject to Varied Power and Steering Angle. **LI YUNFENG et al.** IEEE MICROWAVE AND WIRELESS COMPONENTS LETTERS. IEEE SERVICE CENTER, 11 May 2022, vol. 32, 1243-1246
- **E. G. LARSSON** ; **O. EDFORS** ; **F. TUFVESSON** ; **T. L. MARZETTA**. Massive MIMO for next generation wireless systems. *IEEE Commun. Mag.*, February 2014, vol. 52 (2), 186-195
- **F. BOCCARDI** ; **R. W. HEATH** ; **A. LOZANO** ; **T. L. MARZETTA** ; **P. POPOVSKI**. Five disruptive technology directions for 5G. *IEEE Commun. Mag.*, February 2014, vol. 52 (2), 74-80
- **A. F. MOLISCH et al.** Hybrid beamforming for massive MIMO: A survey. *IEEE Commun. Mag.*, September 2017, vol. 55 (9), 134-141
- **M. ABDELAZIZ** ; **L. ANTTILA** ; **A. BRIHUEGA** ; **F. TUFVESSON** ; **M. VALKAMA**. Digital predistortion for hybrid MIMO transmitters. *IEEE Journal of Selected Topics in Signal Processing*, June 2018, vol. 12 (3), 445-454
- **E. BJORNSON** ; **J. HOYDIS** ; **M. KOUNTOURIS** ; **M. DEBBAH**. Massive MIMO systems with non-ideal hardware: Energy efficiency, estimation, and capacity limits. *IEEE Trans. Inf. Theory*, November 2014, vol. 60 (11), 7112-7139
- **D. R. MORGAN et al.** A generalized memory polynomial model for digital predistortion of RF power amplifiers. *IEEE Trans. Signal Process.*, 2006, vol. 54 (10), 3852-3860
- **SHEPPARD**. Tree-based machine learning algorithms: Decision trees, random forests, and boosting. CreateSpace Ind. Publish. Platform, 2017

- **J. SONG** ; **J. ZHAO** ; **F. DONG** ; **J. ZHAO** ; **Z. QIAN** ; **Q. ZHANG**. A novel regression modeling method for PMSLM structural design optimization using a distance-weighted KNN algorithm. *IEEE Transactions on Industry Applications*, September 2018, vol. 54 (5), 4198-4206
- **M. A. NIELSEN**. Neural networks and deep learning. Determination Press, 2018
- **S. DIKMESE** ; **L. ANTTILA** ; **P. PASCUAL CAMPO** ; **M. VALKAMA** ; **M. RENFORS**. Behavioral modeling of power amplifiers with modern machine learning techniques. *IEEE MTT-S International Microwave Conference on Hardware and Systems for 5G and Beyond*, August 2019
- **C. MOLLEN** ; **U. GUSTAVSSON** ; **T. ERIKSSON** ; **E. G. LARSSON**. Out-of-band radiation measure for MIMO arrays with beamformed transmission. *Proc. IEEE Int. Conf. Commun.*, May 2016, 1-6
- **J. SHEN** ; **S. SUYAMA**. Requirements of power amplifier on super high bit rate massive MIMO OFDM transmission using higher frequency bands. *Proc. IEEE Globecom Workshops*, December 2014, 433-437
- **Y. ZOU et al.** Impact of power amplifier nonlinearities in multi-user massive MIMO downlink. *Proc. IEEE Globecom Workshops*, December 2015, 1-7
- **C. MOLLEN** ; **E. G. LARSSON** ; **U. GUSTAVSSON** ; **T. ERIKSSON** ; **R. W. HEATH**. Out-of-band radiation from large antenna arrays. *IEEE Communications Magazine*, April 2018, vol. 56 (4), 196-203
- **Y. GUO** ; **C. YU** ; **A. ZHU**. Power adaptive digital predistortion for wideband RF power amplifiers with dynamic power transmission. *IEEE Trans. Microw. Theory Techn*, 2015, vol. 63 (11), 1-13